Europäisches Patentamt

European Patent Office

Office européen des brevets

(19)

(11) Publication number: **0 242 635**
**B1**

(12) # EUROPEAN PATENT SPECIFICATION

(45) Date of publication of the patent specification:
**11.07.90**

(51) Int. Cl.⁵: **B41J 3/30,** B41J 9/00,
G06K 15/00, H01F 7/18

(21) Application number: **87104579.5**

(22) Date of filing: **27.03.87**

(54) Control signal profiler for multiple actuator assembly.

(30) Priority: **08.04.86 US 849591**

(43) Date of publication of application:
**28.10.87 Bulletin 87/44**

(45) Publication of the grant of the patent:
**11.07.90 Bulletin 90/28**

(84) Designated Contracting States:
**DE FR GB IT**

(56) References cited:
**DE-A- 2 360 323**
**US-A- 4 291 992**
**US-A- 4 514 737**
**US-A- 4 597 328**

(73) Proprietor: **International Business Machines
Corporation, Old Orchard Road, Armonk, N.Y. 10504(US)**

(72) Inventor: **Karidis, John Peter, 69 Underhill Road,
Ossining, N.Y. 10562(US)**

(74) Representative: **Rudack, Günter O., Dipl.-Ing., IBM
Corporation Säumerstrasse 4, CH-8803 Rüschlikon(CH)**

ACTORUM AG

## Description

This invention relates to wire matrix print actuators, and more particularly relates to a simplified multiple wire matrix print actuator assembly using a simple shared adaptable pulse width modulator as the drive current pulse profiling control for a group of actuator drivers connected by simple decode logic to the source of data, providing overall economy as a result of open loop mode and yet providing very good performance as a result of adaptable drive current pulse profiling.

A great variety of computer print actuator assemblies, described in the prior art, have had high performance as their primary design goal. High power consumption, expensive hardware, and sophisticated timing patterns, including complex shaping of the drive pulses, have been provided in the continuing quest for high performance.

A significant number of other print actuator assemblies, also described in the prior art, have had low cost as their primary design goal. For example, a single high performance print actuator could print an entire line or page by means of a mechanical scan, but this is prohibitively slow for wire matrix printing. Wire matrix print acuators typically are replicated several times in a matrix print actuator printhead assembly; there may be multiple printheads to share the effort; cost thus becomes an important parameter of design.

As the cost has diminished for electronics, particularly for logic and storage, the cost of print actuator assemblies relative to logic and memory has increased. Designers of printers have accordingly sought overall low cost by increasing the amount of electronics associated with each actuator. The constant search for high-quality printing at reasonable cost has not, however, generally minimized both the electronics cost and the actuator cost for overall low cost of a high-speed wire matrix printer system.

The following publications are representative of the prior art:

DE-A 2 360 323 discloses a multiple actuator assembly having a number of electromagnetic coils, each with individual actuator position driver means and a shared control signal profiler for all of the actuators of that actuator assembly.

US-A 3 852 646 shows a high voltage/low voltage sequence drive pulse pattern generator for a solenoid.

US-A 3 922 589 shows a capacitor resistor network and pulse width circuit to adjust the drive pulse to a triangular waveform.

US-A 4 159 882 shows a wire matrix printing technique including bit map timing for vertically overlapping dots to achieve horizontal resolution finer than the nominal dot diameter.

US-A 4 162 131 shows a circuit for providing a fixed amount of energy for a printhead by making the length of the pulse inversely proportional to the time lapse since last firing.

US-A 4 162 858 shows an impact energy control network for a wire matrix printer, using long pulses normally, and alternatively using short pulses if the magnet was actuated on the previous cycle.

US-A-4,173,030 shows a high voltage/low voltage sequence pulse patterning circuit, with high voltage kept on for a variable time to compensate for variations in the pull-in time of a fuel injector.

US-A-4,291,992 shows a wire matrix print pulse patterning network in which each printwire actuator is provided a separate pattern of one long firing pulse followed by a variable number of short damping pulses, as directed by a microprocessor.

US-A-4,314,305 shows a fuel injector solenoid drive circuit pulse patterning network using a fixed voltage and two paths of differing resistance.

US-A-4,440,079 shows a print hammer flight time control system in which delay values, previously determined by measurement of individual hammer flight characteristics, are provided by an external memory to a delay register for each hammer.

US-A-4,485,424 shows a pulse patterner for applying dither to the drive pulse for a solenoid.

US-A-4,514,737 shows the use of a micorprocessor to control timing variations as a function of power supply voltage viariations.

R.H. Sweat, Jr, "Impact Force Compensation for Voltage Variations in the Hammer Firing Pulse in Impact Printer", IBM Technical Disclosure Bulletin, Vol. 22, No. 5, Oct. 1979, pp. 1756-1758, shows a pulse patterning technique for controlling impact force despite voltage variations.

The voluminous prior art may be summarized as providing for pulse profiling for actuator control, on an individual actuator basis, either through analog control networks or through digital electronics.

US-A-4,291,992 and US-A-4,440,079 are representative of techniques for using digital electronics on an individual actuator basis. The former shows a digital electronics technieque for profiling the drive pulse program for best operation of each individual printer pin, using shift registers ans a read only memory. A 256 × 1 memory device is electronically configured as seven 16-bit shift registers, one shift register for each pin. The content of each shift register is provided by computer accessing of a 32 word × 24 bit read only memory, which among other things keeps a short term use history for each pin and provides a pattern for tailoring the acutation pulse for each individual pin in response to activation history for the individual pin. The actuation pulse for each print pin is a burst of pulses including a relatively long firing pulse and a series of from zero to seven relatively short damping pulses, roughly decreasing in number as the interval between pin activations decreases. US-A-4,291,992 uses unminimized electronics to provide a complex actuation pulse pattern profiled to adapt to environmental conditions and to the individual print pin actuation sequence. US-A-4,440,079 shows a timing control system including an external memory device for transfer of pulse profiling information to an individual register for each print hammer. This reference uses unminimized electronics in the form of separate high voltage (unregulated) and low voltage controls gated to the drivers. These digital techniques of the prior art thus teach pulse profiling for each actuator, but do not minimize electronics in applying adaptable pulse profiling to the actuator drivers as a group.

US-A-4,162,131 and US-A-4,162,858 are representative of analog control network techniques of achieving print quality. The former reference shows techniques for controlling the amplitude or duration of the actuation pulse so that the energy applied to the print actuator is the same for each stroke; the actuation pulse is inversely proportional to the time lapse since last firing. The unminimized electronics, used provide a separate drive circuit, including energy control, for each print wire. US-A-4,162,858 shows a simpler technique for supplying either a short drive pulse or a long drive pulse to the individual print actuator depending upon whether the actuator was fired during the previous interval. The latter reference uses uniminimized electronics, providing for each driver separate gating for short and long pulse controls. Chopper drives are conventional. In a representative chopper drive, coil current profiling is done by comparing a feedback signal representing the coil current to a reference signal, thus providing accurate control of the coil current even in the presence of variations in drive voltage or other parameters. Other prior art items show print actuation pulse shaping by a variety of passive element networks, open loop networks and closed loop networks. These analog techniques of the prior art thus teach pulse profiling for performance enhancement, using waveshaping built into network circuits, but do not minimize electronics in applying adaptable pulse profiling to the actuator drivers as a group.

The prior art does not teach nor suggest the invention, which provides overall cost minimization to a high performance multiple wire matrix print actuator assembly by using a single adaptable digital pulse width modulator as the pulse shaping profiling control for the entire group of actuators, and by using simple decoding logic together with the profiling control to operate, in open loop mode, a single-transistor or dual-transistor driver per actuator. Accordingly, the object of the invention is to provide at low cost a multiple actuator assembly with a sophisticated pattern of actuation current, using a simple transistor driver network per actuator, using a simple switching network per actuator for selection logic and control gating of the profiling signal, and sharing open loop profiling control circuits among all actuators of the assembly.

A feature of the invention is its shared use of a precalculated open loop profiling control signal, among a number of simple selection and drive circuits of an assembly of actuators.

An advantage of the invention is good performace at very low cost.

Another advantage of the invention is durability resulting from elegant simplicity.

The foregoing and other objects, features and advantages of the invention will be apparent from the more particular description of the preferred embodiments of the invention, as illustrated in the accompanying drawings,
in which:

Fig. 1 is a schematic diagram of a first embodiment of the invention, using single-transistor drivers.

Fig. 2 is a composite waveform of gating profile and coil current profile for the embodiment of Fig. 1.

Fig. 3 is a schematic diagram of a second embodiment of the invention, using dual-transistor bridge drivers.

Fig. 4 is a composite waveform of gating profile and coil current profile for the embodiment of Fig. 3.

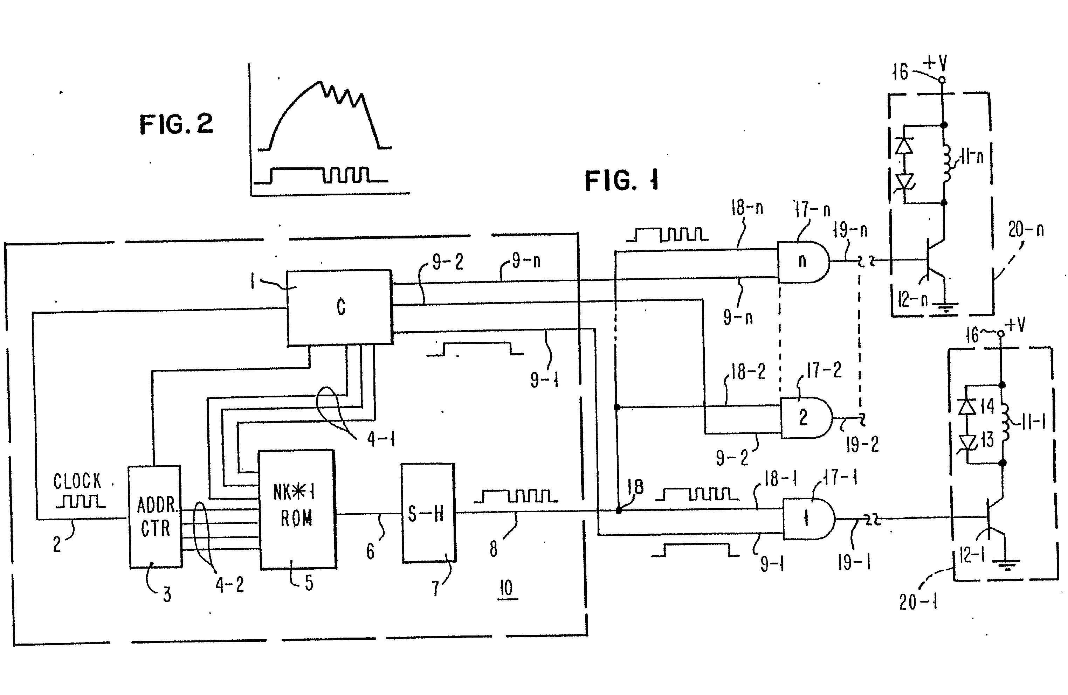

Fig. 1 and Fig. 2 show a preferred embodiment. On the left side, a single shared control signal profiler 10 provides an optimally tailored profiling signal to all the actuators 20 in the group. The actuator group normally is the entire printhead; there is thus only one profiler 10 per printhead in the usual case, only one profiler per assembly. The assembly includes a number of print wires, each having its own driver transistor and decode logic. This profiling control signal is adaptable, and may easily be optimally tailored for efficient high speed operation of a wire matrix print actuator assembly.

Host computer 1 is a microprocessor which serves as a processor means for the profiler. It preferably provides overall control, provides input selections for text control, and conveniently also provides clock signals. It is possible to have a dedicated microprocessor as the processor means, within the profiler 10, having only the function of controlling the profiler, but the shared host computer is preferred. The clock signals arrive, along with other control signals from host computer 1, or from an alternate source, on control lines 2. Address counter 3 and the host computer provide profile address signals on address lines 4-1 and 4-2. Address counter 3 accesses the values digitally stored in the selected profile area of read-only memory 5. Read-only memory (ROM) 5 may conveniently be 1K × 1 bits, if a single nominal coil actuation profile will suffice. If a number of different profiles should be desired, ROM 5 may be extended, for example to NK*5 bits or equivalent for N different profile selections, where address lines 4-1 are used to select the active profile. The output of ROM 5 passes on output line 6 to sample-hold buffer 7, which provides the nominal coil current profile signal on profile signal line 8. The nominal coil current profile signal generally consists of a long pulse followed by a number of short pulses, as shown in Fig. 1 and Fig. 2. Actuator selection signals are supplied on selection lines 9, one line per actuator. The term "processor" is used in its broadest sense, to encompass the combination of the character generation function and the timing function. In practice, the processor can work with the address counter, ROM and clock, or can emulate one or more of these functions.

All items 1-9 together form profiler 10, the control and selection electronics which are shared by the assembly. Profiler 10 is not normally replicated, although all or portions may be replicated for fanout. The following chart shows a simplified representative digital control signal profiling pattern of 1 and 0 values in ROM 5, which pattern is the profiling signal made available on profile signal line 8, which connects to an actuator gating control node:

01111010101000

It is easy to change the digital values in ROM 5 to change the profile. For example, the drive pulse may be lengthened slightly, by an additional short pulse, by changing the penultimate bit from 0 to 1, as follows:

01111010101010

Such changes, under control of host computer 1, may be preset for a single profile or a limited number of profiles. The coil current profile signal can be shared by the entire group (entire printhead assembly) of several actuators because wire-actuators generally fire simultaneously. Some matrix printers, however, do not fire all actuators simultaneously, but rather allow some actuators to be firing slightly earlier, at base time plus 1 T, 2 T, 3 T, etc., while other actuators are firing at base time plus 1.5 T, 2.5 T, 3.5 T, etc., where T is the minimum cycle time of a single actuator. The coil current profiling signal can still be shared by all actuators in this type of printer if the coil current profile signal pattern repeats every 0.5 T, assuming that the required current-on time for each actuator is less than 0,5 T. This contrasts with actuators in an impact line-printer, which do not ordinarily fire simultaneously because their firing time is used to select the desired character from a presentation sequence of characters on a band or wheel.

The preferred way to generate and apply the coil current profiling signal is shown schematically in Fig. 1. Address counter 3 runs at a rate which is roughly three orders of magnitude faster than the maximum actuator repetition rate, to allow for high resolution switching to format the profile for the coil actuation current. In the preferred embodiment, adress counter 3, running at 550 KHz, is used to access sequentially a small block (less than 1K) of single-bit ROM 5. The output of ROM 5 is sent to a sample-and-hold buffer 7, with the buffer 7 output serving as the coil current profiling signal to be shared by all actuators. Counter 3 is reset by host computer 1 at the beginning of each printing cycle. In this manner, any coil current profiling signal with a switching-time resolution of 2 microseconds can be generated simply by storing the appropriate bit pattern in the ROM. Generating the coil current profiling signal in this manner requires some relatively expensive electronics, but the cost is shared by many actuators (up to 24 or more in some printers) and adaptability is convenient. This keeps the overall electronics cost low and keeps the average electronics cost per print wire low.

As desired, the bit pattern stored in ROM 5 can be changed easily so that, for example, the coil current decreases as the air-gap in the actuator closes, thus maintaining just enough magnetomotive force to ensure magnetic saturation. Such current-pulse profiling minimizes the heat dissipated in the coil (a serious problem in high-speed actuators) and maximizes the overall actuator efficiency. Changes of the information in ROM 5, either through computer rewriting of a changeable ROM, or through replacement in an innutable ROM, can thus adapt to changes of paper of typefont, or of ambient temperature, or other environmental situation. These changes are provided by host computer 1 during an appropriate non-print inverval, in accordance with preset or calculated rules.

In summary, the control signal profiler 10 provides a single low-cost, extremely flexible means of controlling the coil current in all actuators of a wire-matrix print actuator assembly.

The wire matrix print actuator assembly includes, for each print actuator, an actuator coil 11-1...11-n and a driver transistor 12-1...12-n, together with appropriate supporting components 13-15, and a connection 16 to a voltage source. Character selection is by host computer 1 as decoded by decoding switches 17-1, 17-2...17-n, which in the preferred embodiment are AND-gates controlled by signals from profiler 10 at actuator prifiling nodes 18-1, 18-2...18-n. AND-gates 17-1, 17-2...17-n are enabled by signals on actuator selection lines 9-1, 9-2...9-n, respectively, to pass the profiling signal to their respective selection and profiling nodes 19-1, 19-2...19-n. Selection and profiling nodes 19-1, 19-2...19-n connect respectively to control input connections of driver transistors 12-1...12-n.

Each actuator 20-1...20-n thus has its own simple selection and profiling electronics, but shares the profiler 10 with all the other actuators of the print actuator assembly. Profiler 10 provides a pulse-width modulated profiling control signal on signal line 8. The pulse-width modulated profiling signal is generated simply, as a series of 1s and 0s which, when integrated by the reactances normally present, provide for the properly tailored current profile in the actuator coils selected. Each actuator coil 11-1...11-n is driven by combinatorially gating individual actuator selection signals together with the shared coil current profiling signal, and applying the gated selection and profiling signal the the base of the selcted driver transistors 12-1...12-n as shown in Fig. 1.

The first pulse in the coil current profiling signal is relatively long to allow the coil current to rise to the desired value. A sequence of shorter pulses is then used to control the current level during the remainder of the actuator drive cycle. This contrasts to a conventio nal chopper-drive, in which coil current profiling is done by comparing a feedback signal representing the coil current to a reference signal, thus providing accurate control of the coil current even in the presence of variations in drive voltage, etc. Sacrifice of the advantages of such accurate current control, to keep costs down, is a good tradeoff in some wire-matrix printers. Therefore, according to this invention, the coil current profiling signal is strictly an open-loop control signal, pre-calculated to provide the desired coil-current pulse shape under operating conditions as measured or as calculated prior to selection or setting of ROM 5.

Fig. 2 shows how a sequence of relatively simple on-off profile signals results in a coil current profile of reasonably fast rise and fall, and reasonable flatness.

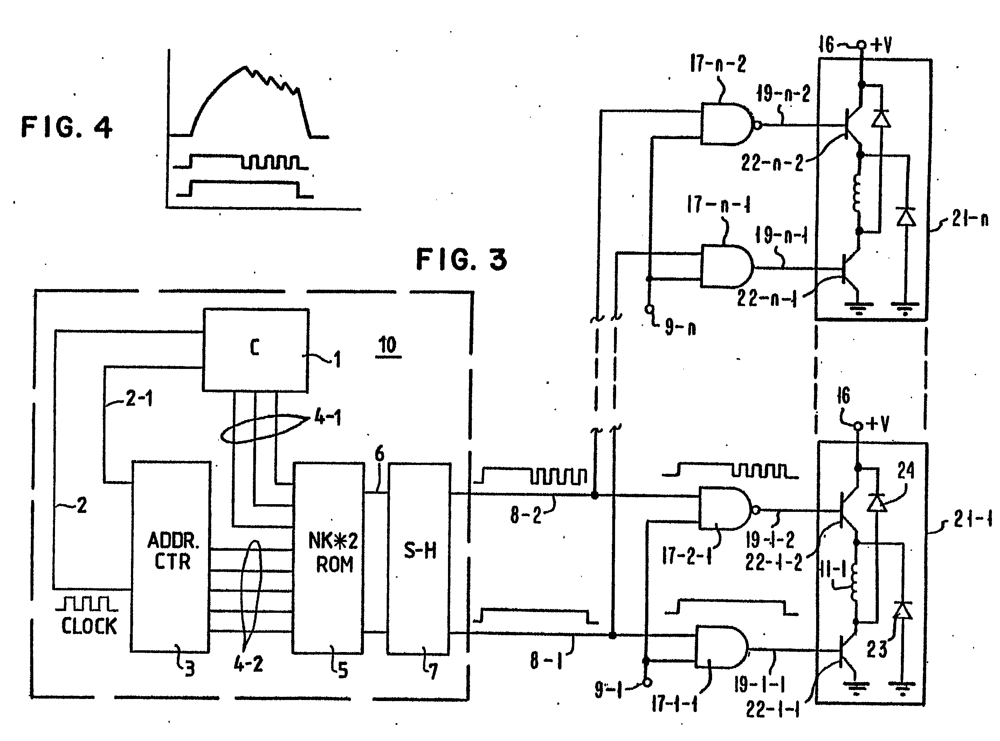

Fig. 3 shows a second embodiment of the invention, featuring two-transistor half-bridge drivers as actuator means, and featuring appropriate two-signal ROM and AND-gate select logic. Most elements of the circuit remain unchanged from the first embodiment and are similarly numbered. Half-bridge drivers 21-1...21-n respectively energize actuator coils 11-1...11-n. The half-bridge driver requires first and second profiles, and the selection logic is replicated to provide first and second selections. ROM 5 is an NK*2 array, providing two outputs, on output lines 6, to sample-hold buffer 7. Selection logic for each actuator position includes decoding switches 17-n...17-n-2.

In operation, host computer 1 provides a control signal on control line 2 to reset address counter 3. An additional control signal on clock control line 2-1 operates address counter 3 to provide low-order addressing signals on low-order addressing lines 4-2 to ROM 5. Host computer 1 provides high-order addressing signals on high order addressing lines 4-1. The terms low-order and high-order are nomenclature only; the nature of addressing a read-only memory permits great flexibility in addressing the information stored in ROM. The number of address lines 4-1 is determined by the number of bits desired for each profile. The number of address lines 4-2 is determined by the desired number of profiles. This provides a great number of values, sufficient in precision to provide all necessary profiling values, via output lines 6 and sample-hold buffer 7 to decoding switches 17-1-1...17n-2. Selection values from host computer 1 are provided on selection lines 9-1...9-n to make appropriate actuator selection for the characters or images desired for printing.

A typical half-bridge driver comprises a first transistor 22-n-1 and a second transistor 22-n-2, plus two diodes 23 and 24. In operation, both transistors 22-n-1 and 22-n-2 must conduct to provide full current through coil 11-n. Transistor 22-n-2 is provided with the switching profile desired, while transistor 22-n-1 is provided with an envelope profile as shown. At print time, microprocessor 1 resets counter 3 to start the profiling. Decoding switches 17-n-1 and 17-n-2 select their respective half-bridge driver coils, through preconditioning by their respective select signals, to pass current in response to the profiles. Upon receipt of the first profiling 1 after select at first transistor 22-n-1, and upon simultaneous receipt of the first profiling signal 1 after a select signal at the second transistor 22-n-2, current passes from power source V node 16 through the second transistor 22-n-2, through coil 11-n, through first transistor 22-n-1, to ground. When the profile signal 0 appears, second transistor 22-n-21 turns off. Inductance tends to continue current from ground through grounded diode 23, coil 11-n and first transistor 22-n-1 back to ground. As the first transistor remains conductive, the second transistor tunrs on and off as 1's on 0's appear in its profiling signal, providing appropriately profiled current to coil 11-n. When both profiles become 0, both transistors are off, and the current in coil 11-n decays quickly from ground through grounded diode 23, coil 11-n, discharge diode 24 and node V to the power supply node 16.

Fig. 4 shows simplified on-off profiles for transistors 22 and 23, and the resulting coil current waveform.

Complex profiles may be provided, and changed as appropriate, simply by changing the 1-0 pattern. A representative set of complex profiles for the embodiment of Fig. 2 is as follows:

(8-1) 01111111111111111111...111111111111111111...1000
(8-2) 00111111111111111110...011111110001110001...0000

**Claims**

1. Multiple actuator assembly having a number of electromagnetic coils (11), each with individual actuator position driver means (12, 17), and a shared control signal profiler (10) for all of the actuators (20, 21) of the actuator assembly, characterized in that said signal profiler (10) comprises selection means (1) for providing selection signals, clock means (2), an address counter (3) connected to said clock means (2); and a memory (5) connected for addressing by said address counter (3) to provide a timed sequence of readouts of previously stored values defining an electromagnetic coil actuation control profile; and profiling selection means (6-9 and 17-19) connected to said memory (5) to provide open loop profiling selection signals to selected individual actuator position driver means (20); whereby each selected one of said plurality of individual actuator coils (11) receives controlled profile coil current in response to profiling selection signals in open loop format.

2. Actuator assembly in accordance with Claim 1, characterized in that said memory (5) is a read-only memory, said address counter (3) is clock-driven by said clock means (2) and is connected to said read-only memory (5) on connecting lines (4-2), and that said selection means (1, 4-1) comprised by said shared control signal profiler (10) are connected to said read-only memory (5).

3. Actuator assembly in accordance with Claim 1, characterized in that the control signal profiler (10) comprises an address counter (3), a read only memory (5) connected for addressing by said address counter (3), and buffering means (7) connected to said read only memory (5), to provide an open loop profiling signal at an actuator profiling node (18); that said signal profiler (10) is connected to a plurality of actuators (20-1...20-n), one for each actuator position, each actuator comprising a decoding switch (17-1...17-n) having connection including an output selection and profiling node (19-1...19-n), a selection input on a respective actuator selection line (9-1...9-n), and a profiling input from said actuator profiling node (18-1...18-n); a driver transistor (12-1...12-n) with appropriate support components (13-1...13-n, 15-1...15-n), connected to said associated decoding switch (17-1...17-n), for profile controlled coil actuation in response to selection and profiling signals at said selection and profiling nodes (19-1...19-n), and that said actuator coil (11) is connected to said driver transistor (12-1...12-n).

4. Actuator assembly in accordance with Claim 1, characterized in that said control signal profiler (10) comprises a processor (1) connected to provide control input signals on connecting lines (4-1) connected to said read only memory (5) and further connected on selection lines (9) for driver selection, and that said control signal profiler (10) further comprises said address counter (3) connected to said read only memory (5) on connecting lines (4-2), said control signal profiler (10) providing open loop print selection control signals.

5. Actuator assembly in accordance with Claim 1, characterized in that said selection means (1) comprises a processor to provide clocking signals and address signals; that an address counter (3) connected to said processor (1) is provided for scanning a sequence of addresses; that a read only memory (5) connected to said address counter (3) is provided for supplying stored digital profiling control values upon scanning of a sequence of addresses; that there is a voltage supply (16), to supply power at a nominal voltage; that a finite plurality of actuators (21-1...21-n) is provided, each including an electromagnetic coil (11-1...11-n); a similar finite plurality of controllable half-bridge driver actuators (21-1...21 n), each connected to said voltage supply (16) and each connected to supply power to a related one of said plurality of actuators (20, 21) and having a connection to an actuator selection line (9-1...9-n); and a similar finite plurality of pairs of decoding switches (17-1-1, 17-1-2,...17-n-1, 17-n-2), each connected respectively to a related one of said actuator selection lines (9-1...9-n), connected for pulse profiling control to said read only memory (5), and connected for selection to said processor (1) as a source of control input information, to supply to selected ones of said plurality of bridge drivers (21-1...21-n) appropriate selection and profiling signals as a function of predetermined pulse width modulated control values; whereby each selected actuator coil (11-1...11-n) integrates the applied pulse width modulated values, in effect receiving a profiled current pulse appropriate for operation optimized as adapted for best performance of the print actuator assembly.

6. Actuator assembly in accordance with Claim 5, characterized in that said control signal profiler (10) comprises a processor (1) connected to provide control input information on connecting lines (4-1) connected to said read only memory (5) and further connected on connecting lines (9) for driver selection, and that said control signal profiler (10) further comprises said address counter (3) connected to said read only memory (5) on connecting lines (4-2), whereby said control signal profiler (10) provides open loop print selection signals.

## Patentansprüche

1. Vielfach-Betätigungsvorrichtung mit einer Anzahl von elektromagnetischen Spulen (11), die jeweils den Betätigungspositionen individuell zugeordnete Treiber (12, 17) aufweisen, und mit einem gemeinsamen Steuersignalformer (10) für sämtliche Betätigungsglieder der Betätigungsvorrichtung, dadurch gekennzeichnet, daß der Steuersignalformer (10) Auswahlmittel (1) zum Abgeben von Wählsignalen, einen Taktgeber (2), einen mit dem Taktgeber (2) verbundenen Adreßzähler (3) und einen für die Adressierung durch den Adreßzähler (3) angeschlossenen Speicher (5) aufweist, um eine getaktete Folge von ausgelesenen, vorher gespeicherten Werten im offenen Regelkreis für die ausgewählten, individuell zugeordneten Treiber (20) bereitzustellen, wobei jede Spule, die aus der Vierzahl von elektromagnetischen Spulen (11) ausgewählt wurde, einen Spulen-Steuerstrom mit von den Auswahlsignalen im offenen Regelkreis bestimmtem, kontrolliertem Profil erhält.

2. Betätigungsvorrichtung gemäß Anspruch 1, dadurch gekennzeichnet, daß der genannte Speicher (5) als Festspeicher ausgebildet ist, daß der genannte Adreßzähler (3) von dem genannten Taktgeber (2) gesteuert und mit dem Festspeicher (5) über Verbindungsleitungen (4-2) verbunden ist, und daß die genannten, im gemeinsamen Steuersignalformer (10) vorgesehenen Auswahlmittel (1, 4-1) mit dem genannten Festspeicher (5) verbunden sind.

3. Betätigungsvorrichtung gemäß Anspruch 1, dadurch gekennzeichnet, daß der Steuersignalformer (10) einen Adreßzähler (3), einen zum Adressieren mit dem Adreßzähler (3) verbundenen Festspeicher (5) und einen Puffer (7) umfaßt, der an den Festspeicher (5) angeschlossen ist, um ein Profilsignal für den offenen Regelkreis an einen Betätigungsglied-Knotenpunkt (18) zu liefern, daß der genannte Steuersignalformer (10) an eine Vielzahl von Betätigungsgliedern (20-1...20-n) angeschlossen ist, die je einer Betätigungsposition zugeordnet sind, wobei jedes Betätigungsglied einen Entschlüsselungsschalter (17-1...17-n) sowie einen Auswahl- und Profil-Knotenpunkt (19-1...19-n) aufweist, einen Auswahl-Eingang an einer zugeordneten Betätigungsglied-Auswahlleitung (9-1...9-n), und einen Profil-Eingang von dem genannten Betätigungsglied-Profil-Knotenpunkt (18-1...18-n), einen Treiber-Transistor (12-1... 12-n) mit entsprechenden Schaltelementen (13-1...13-n; 15-1...15-n), die mit dem genannten zugeordneten Entschlüsselungsschalter (17-1...17-n) verbunden sind, für eine profilkontrollierte Betätigung der Spulen aufgrund der genannten Auswahl- und Profilsignale an den genannten Auswahl- und Profil-Knotenpunkten (19-1...19-n), und daß die genannte Betätigerspule, (11) mit dem genannten Treiber-Transistor (12-1...12-n) verbunden ist.

4. Betätigungsvorrichtung gemäß Anspruch 1, dadurch gekennzeichnet, daß der Steuersignalformer (10) einen Prozessor (1) aufweist, der zum Abgeben von Steuersignalen mit Verbindungsleitungen (4-1) verbunden ist, die an den Festspeicher (5) und ferner an Auswahlleitungen (9) für die Auswahl der Treiber angeschlossen sind, und daß der Steuersignalformer (10) auch den genannten Adreßzähler (3) umfaßt, der über die Leitungen (4-2) mit dem Festspeicher (5) verbunden ist, wobei der Steuersignalformer (10) Druck-Auswahl-Steuersignale in den offenen Regelkreis abgibt.

5. Betätigungsvorrichtung gemäß Anspruch 1, dadurch gekennzeichnet, daß die genannten Auswahlmittel (1) einen Prozessor für die Bereitstellung von Taktsignalen und Adreßsignalen aufweisen, daß ein mit dem genannten Prozessor (1) verbundener Adreßzähler (3) vorgesehen ist, der die Adressensequenz abtastet, daß ein mit dem Adreßzähler (3) verbundener Festspeicher (5) vorgesehen ist, der aufgrund der Abtastung einer Adreßfolge gespeicherte digitale Profil-Steuersignale abgibt, daß eine Stromversorgung (16) vorhanden ist, die eine Spannung bestimmter Größe liefert, daß eine endliche Anzahl von Betätigungsgliedern (21-1...21-1) vorgesehen ist, die jeweils eine elektromagnetische Spule (11-1...11-n) aufweisen; eine gleichermaßen endliche Anzahl von steuerbaren Halbbrücken-Treiber-Betätigungsgliedern (21-1...21-1), die an die genannte Stromversorgung (16) angeschlossen sind und Spannung an ein zugeordnetes der Betätigungsglieder (21-1...21-1) liefern und eine Verbindung aufweisen zu einer Auswahlleitung (9-1...9-n), und eine gleichermaßen endliche Anzahl von Paaren von Entschlüsselungsschaltern (17-1-1, 17-1-2,...17-n-1, 17-n-2), die jeweils mit einer zugeordneten der Auswahlleitungen (9-1...9-n) verbunden sind, um dem Festspeicher (5) Impulsprofil-Steuersignale zu übermitteln, und die zum Auswählen verbunden sind mit dem genannten Prozessor (1) als einer Quelle von Eingangssteuerinformation, um ausgewählten aus der Vielzahl von Brückentreibern (21-1...21-n) entsprechende Auswahl- und Profil-Signale als Funktion vorbestimmter pulsbreitenmodulierter Steuerwerte zu liefern, wobei jede ausgewählte Betätigerspule (11-1...11-n) die anliegenden pulsbreitenmodulierten Steuerwerte integriert und tatsächlich einen profilierten Stromimpuls empfängt, der geeignet ist für den optimierten Betrieb mit bestmöglicher Arbeit der Betätigungsvorrichtung.

6. Betätigungsvorrichtung gemäß Anspruch 5, dadurch gekennzeichnet, daß der Steuersignalformer (10) einen Prozessor (1) aufweist, der zum Abgeben von Steuersignalen mit Verbindungsleitungen (4-1) verbunden ist, die an den Festspeicher (5) und ferner an Auswahlleitungen (9) für die Auswahl der Treiber angeschlossen sind, und daß der Steuersignalformer (10) auch den genannten Adreßzähler (3) umfaßt, der über die Leitungen (4-2) mit dem Festspeicher (5) verbunden ist, wobei der Steuersignalformer (10) Druck-Auswahl-Steuersignale in den offenen Regelkreis abgibt.

**Revendications**

1. Ensemble à actionneurs multiples, comportant un certain nombre de bobines électromagnétiques (11), comprenant chacune des moyens (12, 17) de commande de la position d'un actionneur individuel, et un dispositif commun (10) de profilage de signaux de commande pour tous les actionneurs (20, 21) de l'ensemble à actionneurs, caractérisé en ce que ledit dispositif (10) de profilage des signaux comporte des moyens de sélection (1) servant à délivrer des signaux de sélection, des moyens formant horloge (2), un compteur d'adresses (3) raccordé auxdits moyens formant horloge (2); et une mémoire (5) raccordée pour permettre l'adressage par ledit compteur d'adresses (3) de manière à fournir une séquence cadencée de lectures de valeurs antérieurement mémorisées définissant un profil de commande d'actionnement d'une bobine électromagnétique; et des moyens (6-9 et 17-19) de sélection de profilage raccordés à ladite mémoire (5) pour envoyer des signaux de sélection de profilage en boucle ouverte à des moyens (20) de commande de position d'actionneurs individuels sélectionnés; chaque bobine sélectionnée faisant partie de ladite pluralité de bobines (11) d'actionneurs individuels recevant un courant de bobine à profil commandé, en réponse à des signaux de sélection de profilage, dans un format à boucle ouverte.

2. Ensemble à actionneurs selon la revendication 1, caractérisé en ce que ladite mémoire (5) est une mémoire morte, ledit compteur d'adresses (3) est piloté de façon cadencée par lesdits moyens formant horloge (2) et est raccordé à ladite mémoire morte (5) par l'intermédiaire de conducteurs de raccordement (4-2), et que lesdits moyens de sélection (1, 4-1) contenus dans ledit dispositif commun (10) de profilage de signaux de commande sont raccordés à ladite mémoire morte (5).

3. Ensemble à actionneur selon la revendication 1, caractérisé en ce que le dispositif (10) de profilage des signaux de commande comporte un compteur d'adresses (3), une mémoire morte (5) raccordée de manière à permettre un adressage par ledit compteur d'adresses (3), et des moyens de tamponnage (7) raccordés à ladite mémoire morte (5) de manière à former un signal de profilage en boucle ouverte au niveau d'un nœud (18) de profilage des signaux des actionneurs; que ledit dispositif (10) de profilage de signaux est raccordé à une pluralité d'actionneurs (20-1...20-n), un pour chaque position d'un actionneur, chaque actionneur comportant un commutateur de décodage (17-1...17-n) comportant une connexion incluant un nœud (19-1...19-n) de sélection et de profilage de signaux de sortie, une entrée de sélection située dans un conducteur (9-1... 9-n) de sélection d'un actionneur respectif, et une entrée de profilage reliée audit nœud (18-1...18-n) de profilage d'un actionneur; un transistor d'attaque (12-1...12-n) comportant des composants de support appropriés (13-1...13-n, 15-1...15-n), raccordés audit commutateur de décodage associé (17-1...17-n), pour l'actionnement d'une bobine commandée par un profil de signal, en réponse à la sélection et au profilage de signaux au niveau desdits nœuds de sélection et de profilage (19-1...19-n), et que ladite bobine (11) de l'actionneur est raccordée audit transistor d'attaque (12-1...12-n).

4. Ensemble à actionneurs selon la revendication 1, caractérisé en ce que ledit dispositif (10) de profilage des signaux de commande comporte un processeur (1) raccordé de manière à délivrer des signaux d'entrée de commande présents dans des conducteurs de raccordement (4-1) raccordés à ladite mémoire morte (5) et raccordés en outre à des conducteurs de sélection (9) pour réaliser la sélection des étages d'attaque, et que ledit dispositif (10) de profilage des signaux de commande contient en outre ledit compteur d'adresses (3) raccordé à ladite mémoire morte (5) par l'intermédiaire de conducteurs de raccordement (4-2), ledit dispositif (10) de profilage des signaux de commande délivrant des signaux de commande de sélection d'impression en boucle ouverte.

5. Ensemble à actionneurs selon la revendication 1, caractérisé en ce que lesdits moyens de sélection (1) comprennent un processeur servant à délivrer des signaux d'horloge et des signaux d'adresses; un compteur d'adresses (3) raccordé audit processeur (1) et prévu pour explorer une séquence d'adresses; qu'une mémoire morte (5) raccordée audit compteur d'adresses (5) est prévue pour délivrer des valeurs numériques de commande de profilage mémorisées, lors de l'exploration d'une séquence d'adresses; qu'il est prévu une alimentation en tension (16) servant à délivrer une énergie à une tension nominale; qu'il est prévu une pluralité limitée d'actionneurs (21-1...21-n), dont chacun comporte une bobine électromagnétique (11-1...11-n); une pluralité limitée similaire d'actionneurs (21-1...21-n) d'étages d'attaque commandables montés en demi-pont et dont chacun est raccordé à ladite alimentation (16) et est raccordé de manière à envoyer une énergie à un actionneur associé faisant partie de ladite pluralité d'actionneurs (20, 21) et comportant une connexion de liaison à un conducteur (9-1...9-n) de sélection d'un actionneur; et une pluralité limitée similaire de couples de commutateurs de décodage (17-1-1, 17-1-2...17-n-1, 17-n-2), dont chacun est raccordé respectivement à un conducteur associé faisant partie desdits conducteurs (9-1...9-n) de sélection des actionneurs, et est raccordé à ladite mémoire morte (5) pour réaliser une commande du profilage d'impulsions, et est raccordé, pour réaliser la sélection, audit processeur (1) en tant que source d'informations d'entrée de commande, de manière à envoyer à des étages d'attaque sélectionnés de ladite pluralité d'étages d'attaque (21-1...21-n) montés en pont, des signaux appropriés de sélection et de profilage en fonction de valeurs de commande prédéterminées selon une modulation d'impulsions en durée; ce qui a pour effet que chaque bobine sélectionnée 11-1...11-n) d'un actionneur intègre les valeurs appliquées, modulées selon une modulation d'impulsions en durée, en recevant une impulsion de courant profilée convenant pour un fonctionnement optimisé d'une manière adaptée pour fournir la meilleure performance de l'ensemble à actionneurs d'impression.

6. Ensemble à actionneurs selon la revendication 5, caractérisé en ce que ledit dispositif (10) de profilage de signaux de commande comporte un processeur (1) raccordé de manière à délivrer une information d'entrée de commande dans des conducteurs de raccordement (4-1) raccordés à ladite mémoire morte (5) et raccordés en outre à des conducteurs de raccordement (9) permettant de réaliser une sélection d'étages d'attaque, et que ledit dispositif (10) de profilage des signaux de commande comporte en outre ledit compteur d'adresses (3) raccordé à ladite mémoire morte (5) par l'intermédiaire de conducteurs de raccordement (4-2), ce qui a pour effet que ledit dispositif (10) de profilage des signaux de commande délivre des signaux de sélection de répression en boucle ouverte.

FIG. 2

FIG. 1

EP 0 242 635 B1

FIG. 4

FIG. 3

EP 0 242 635 B1